# EUROPEAN PATENT SPECIFICATION

(11) **EP 0 545 484 B1**
(45) Date of publication and mention of the grant of the patent: **13.08.2003**
(21) Application number: 92203670.2
(22) Date of filing: 27.11.1992
(51) Int. Cl.: H01L 21/336, H01L 29/772

(54) **Manufacturing process for insulated gate field effect transistors (igfet) with low short circuit density between gate and source and devices obtained thereby**
Verfahren zur Herstellung von Feldeffekttransistoren mit isoliertem Gatter (IGFET) und niedriger Kurzschlussdichte zwischen Gatter und Quelle; dadurch hergestellte Bauelementen
Procédé de fabrication de transistors à effet de champ à forte isolée (IGFET) ayant une faible densité de court-circuit entre la source et la porte; dispositif ainsi obtenus

(30) Priority: 05.12.1991 IT MI913267
(43) Date of publication of application: 09.06.1993
(73) Proprietor: Consorzio per la Ricerca sulla Microelettronica nel Mezzogiorno - CoRiMMe, 95121 Catania (IT)
(72) Inventor: Zambrano, Raffaele, I-95037 San Giovanni La Punta CT (IT)
(74) Representative: Arena, Giovanni

(56) References cited:
- EP-A- 0 437 939
- DE-A- 3 901 369
- PATENT ABSTRACTS OF JAPAN vol. 013, no. 407 (E-818), 8 September 1989 & JP 01 146367 A (NEC CORP), 8 June 1989,
- PATENT ABSTRACTS OF JAPAN vol. 012, no. 108 (E-597), 7 April 1988 & JP 62 238669 A (NEC CORP), 19 October 1987,
- PATENT ABSTRACTS OF JAPAN vol. 013, no. 481 (E-838), 31 October 1989 & JP 01 189175 A (MATSUSHITA ELECTRIC WORKS LTD), 28 July 1989,

## Description

The present invention relates to manufacturing process for insulated gate field effect transistors (IGFET) with low short circuit density between gate and source and the devices obtained thereby.

The manufacturing process for an insulated gate field effect transistor involves a series of operations among which are epitaxial growth of an N- silicon layer on an N+ monocrystalline silicon substrate, surface oxidation of said layer for formation of the field oxide, definition of the deep body region and the active areas of the device, growth of a gate oxide layer, deposit and doping of a polycrystalline silicon layer and definition of the gate, body and source regions.

One shortcoming often occurring is the presence in the gate oxide of the finished device of yielding and fractures ('holes') which cause deviations because they generate short circuits between the gate polycrystalline silicon and the body and source regions below.

Additional short circuits can also be generated between the gate polycrystalline silicon and the type N epitaxial layer underlying the gate oxide, thus causing short circuiting of the gate with the drain. The purpose of the present invention is to obviate said shortcomings of the standard process by using processes allowing provision of devices with reduced danger of short circuits between gate and source.

Manufacturing processes for field effect transistor are disclosed in the documents DE-A-03 901 369, JP-A-01 146 367 and in JP-A-62 238 669.

In DE-A-03 901 369 a method is described for realizing a DMOSFET with a high breakdown voltage by forming channel regions, well regions and source regions in a semiconductor wafer, than forming gate, source and drain electrodes and further by ion implantation of an impurity material of the same conductivity type as the wafer into the channel regions.

In JP-A-01 146 367 a process is described to provide a field effect transistor freed of variation of characteristics due to dislocation of a gate electrode and having a gate oxide film of improved quality, by utilizing LOCOS produced by selective oxidation using a silicon nitride film as a mask for formation of a gate so that a thick SiO₂ film can be formed under the outer periphery of the gate electrode.

In JP-A-62 238 669 a method is described to improve the controllability of a threshold voltage value, by forming a P-base and an N⁺ source with a nitride film as a mask, thereafter removing the nitride film, and implanting ions in the entire surface or in only a part of the place, where the nitride film has been located.

The process in accordance with the present invention is characterized in that the operations of definition and diffusion of the body and source regions are performed before deposit of the gate polycrystalline silicon layer as set forth in the following claim 1.

To further clarify the innovative principles of the present invention and its advantages as compared with the known art there is described below with the aid of the annexed drawings a possible embodiment as nonlimiting example.

In the drawings:
FIG.1 shows an example of a structure for an IGFET,
FIGS.2-8 show cross sections of an IGFET in different processing phases of an example of a process in accordance with the present invention.

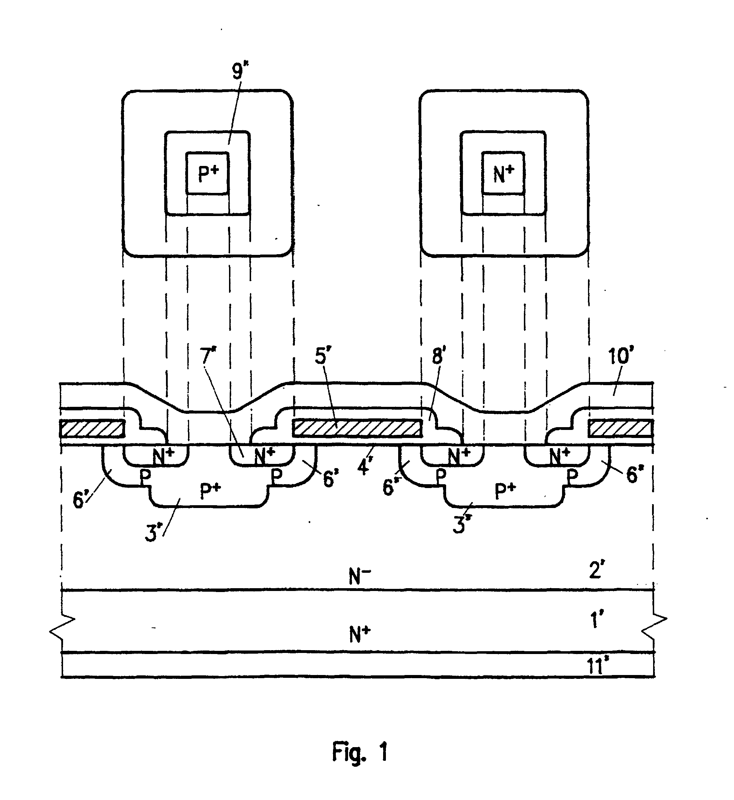

FIG.1 shows an example of a structure of an IGFET.

A standard process for accomplishment of said structure calls for the following phases:
- epitaxial growth of a layer 2' of N- silicon on a substrate 1' of low resistivity type N+ monocrystalline silicon,
- surface oxidation of the layer 2' (field oxidation),
- definition of a type P layer with high dopant concentration designed for formation of the deep body region 3' by three successive operations of masking, implantation and diffusion,
- definition by masking of the active areas of the device,
- growth of a layer of gate oxide (SiO₂) on the active areas (of which at the end of the process there remains a trace in the layer 4' underlying the gate polycrystalline silicon 5'),
- deposit and doping of a polycrystalline silicon layer on the gate oxide,
- definition of the gate regions by selective etching of the polycrystalline silicon,
- definition of the body region 6' (type P) and source regions 7' (type N) for formation of the power MOS channel,
- deposit of an oxide layer 8' (PSG) on the polycrystalline silicon to completely insulate it,
- definition of the contact area 9',
- metallization 10' of the front,
- covering of the metallization with glass or other passivating materials (not indicated in the figures), and
- metallization 11' of the back of the device.

The above process, while on the one hand it allows self-alignment of the gate polycrystalline silicon with the body and source regions and hence with the channel region, on the other hand it frequently gives rise, as mentioned above, to 'holes' in the gate oxide layer 4'.

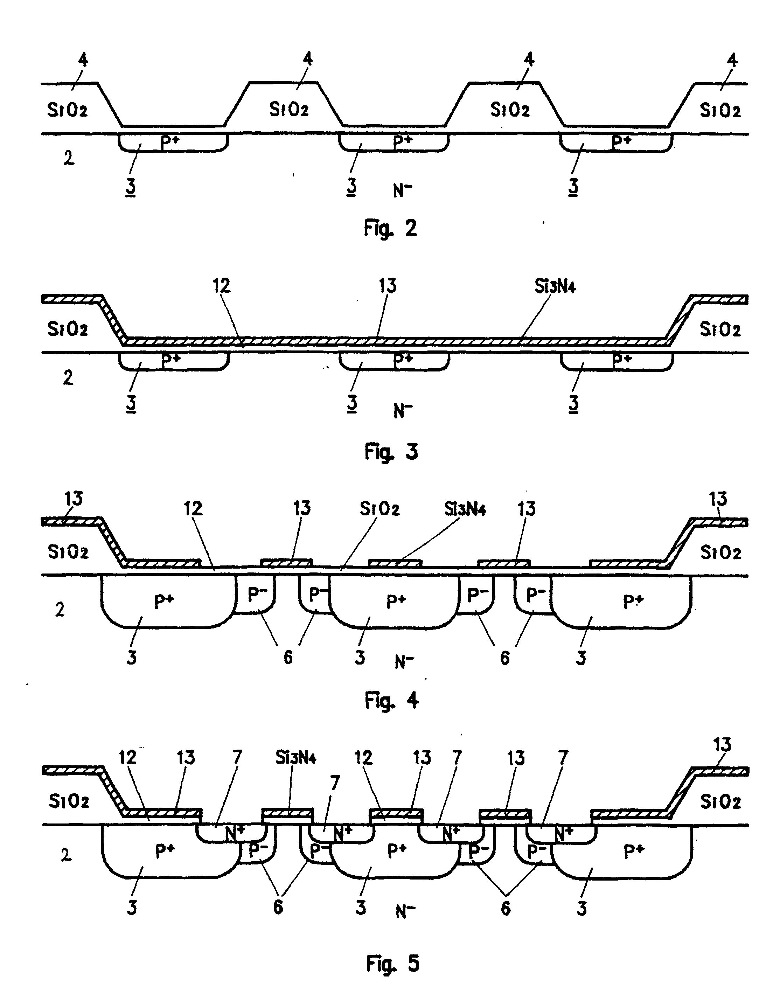

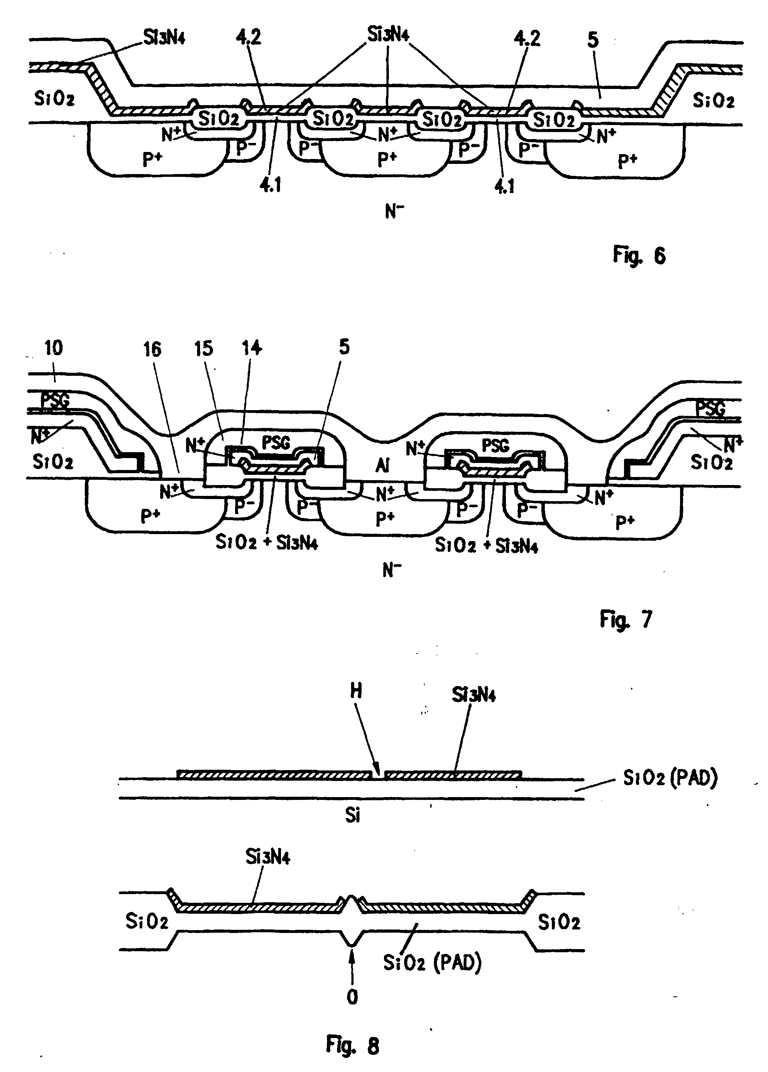

An example of an embodiment of the process in accordance with the present invention is now described with reference to FIGS.2-7 which illustrate a cross section of an IGFET in different processing phases. The phases of said process are:
1) Epitaxial growth of a type N- silicon layer 2 on an N+ low resistivity monocrystalline substrate (not shown in FIG. 2).
2) Surface oxidation of the slice with formation of the field oxide 4 (SiO₂).
3) Three successive operations of masking, implantation and diffusion for definition of a type P layer 3 with high dopant concentration designed for formation of the deep body (FIG. 2 represents a cross section of the device at the end of this phase).
4) Photolitography of the field oxide.
5) Growth of the pad oxide 12.
6) Deposit of a layer 13 of nitride Si₃N₄ on the pad oxide (FIG. 3 represents a cross section of the device at the end of this phase).
7) Photolitography for definition of the body region 6 and source region 7 performed after deposit of a layer of resist.
8) Etching of the layer 13 of Si₃N₄.
9) Ionic implantation of the body (P-).
10) Removal of the resist layer deposited during photolitography of the body and source.
11) Diffusion of the P- dopant (P- body) which will serve to form the channel zones (FIG. 4 represents a cross section of the device at the end of this phase).
12) Etching of the pad oxide 12 in the zones not covered by the nitride 13.
13) Implantation of dopant (n+) to form the source 7 (FIG. 5 represents a cross section of the device at the end of this phase).
14) Diffusion of the dopant N+ (source) accompanied by surface oxidation for formation of the channel.
15) Deposit of the polycrystalline silicon 5.
16) Doping of the polycrystalline silicon (FIG. 6 represents a cross section of the device at the end of this phase).
17) Photolitography for etching of the polycrystalline silicon on the front of the slice except the gate regions.
18) Oxidation 14 of the polycrystalline silicon.
19) Deposit of a layer 15 of oxide (PSG) on the polycrystalline silicon to completely insulate it.
20) Photolitography for definition of the contacts (contact areas 16).
21) Metallization 10 of the front of the slice.
22) Metal photolitography (FIG. 7 represents a cross section of the device at the end of this phase).
23) Covering of the metallization with glass or other passivating materials (not shown in FIG. 7).
24) Metallization of the back of the slice (not shown in FIG. 7).

As seen in this example of a process in accordance with the present invention definition and diffusion of the body and source regions takes place before deposit of the gate polycrystalline silicon and this is made possible using for definition of said regions a layer of pad oxide and a layer of silicon nitride overlying it. Said layers allow self-alignment of the body and source regions and are also used as gate dielectric (see layers 4.1 and 4.2 of pad oxide and nitride in Fig.6) in place of the gate oxide of the standard process.

The definition and diffusion of the body and source regions before deposit of the gate polycrystalline silicon gives the following advantages:
I) The gate oxide which grows on the source regions (phase 14) is thicker than in the other regions since the speed of growth of the oxide on top of a strongly doped type N region is higher, consequently:
   a) there is reduced possibility of occurrence of 'holes' in the gate dielectric, i.e. reduced possibility of occurrence of short circuits between gate and source in this region, and
   b) there is reduced parasite capacitance between these two regions.
II) The body and source regions are self-aligned with each other because implanted through the same geometry, defined by the body/source photolitography.

Moreover there are additional advantages made clear by the following considerations. The pair of the two gate dielectrics (pad oxide + nitride) used in the second example is intrinsically stronger than the single layer of gate oxide and this helps reduce significantly the density of short circuits between gate and drain and between gate and source. Indeed:
- the nitride (often only approximately 0.1 micron versus the thickness of approximately 0.5 micron of the polycrystalline silicon) subjects the underlying oxide to less stress and, even in the eventuality of yielding of the latter, the defects in the oxide are covered by a layer of insulating material (the nitride);
- the presence of any 'holes' in the nitride is not a big problem because opposite these holes grows a rather thick oxide during phase 14 of N+ diffusion/oxidation (the mechanism of this oxide growth opposite holes in the nitride is exemplified in FIG.8, which shows how the hole H present in the nitride before said phase 14 is filled by the oxide O at the end of said phase).

It is observed that although processes for n-channel have been described they can be applied with obvious variants also to p-channel transistors: in this case it suffices to interchange all the type p regions with type n regions. Of course said transistors can be provided both discretely and in the framework of integrated circuits.

It is also possible to use the processes in accordance with the present invention to provide conductivity modulation devices, known as IGBTs (Insulated Gate Bipolar Transistors). In this case it is necessary to replace the type n+ substrate by a type p+ substrate in accordance with techniques known to those skilled in the art.

## Claims

1. A process of manufacturing an insulated gate field effect transistor comprising the following steps:
a) epitaxial growth of a lowly doped silicon layer (2) having a first conductivity type on a highly doped monocrystalline silicon substrate;
b) surface oxidation of said lowly doped silicon layer (2) and patterning to form field oxide regions (4);
c) implantation and diffusion of impurities of a second conductivity type opposite to said first conductivity type to form highly doped deep body regions (3) in said lowly doped silicon layer (2);
d) removing selected field oxide regions by means of photolithography to expose the surface of said lowly doped silicon layer (2) and said highly doped deep body regions (3);
e) growth of a pad oxide layer (12) on the exposed surface of said lowly doped silicon layer (2) and said highly doped deep body regions (3);
f) deposition of a silicon nitride layer (13) on said pad oxide layer (12);
g) patterning of said silicon nitride layer by means of a photoresist mask and etching of said silicon nitride layer (13) to leave silicon nitride layer regions over said highly doped deep body regions (3) and over said lowly doped silicon layer (2) between said highly doped deep body regions (3) for definition of lowly doped body regions (6) and highly doped source regions (7) to be formed.
i) implantation of impurities of said second conductivity type utilising said photoresist mask and said silicon nitride regions as a mask and diffusion to form said lowly doped body regions (6) in said lowly doped silicon layer beside said highly doped deep body regions (3);
j) removing of said pad oxide layer (12) in the zones not covered by said silicon nitride regions (13) by etching to form pad oxide regions below said silicon nitride regions;
k) implantation of impurities of said first conductivity type followed by diffusion accompanied by surface oxidation utilising said silicon nitride regions and said pad oxide regions as a mask to form to form said highly doped source regions (7) within said highly doped deep body regions and said lowly doped body regions and to form oxide regions on said highly doped source regions (7)
l) deposition and doping of a polycrystalline silicon layer (5) on the obtained structure after step k); and
m) patterning said polycrystalline silicon layer utilising photolithography and etching of the polycrystalline silicon layer to form a gate over said silicon nitride regions, said pad oxide regions and said oxide regions.

2. A process according to claim 1 wherein said monocrystalline silicon substrate is of said second conductivity type to provide conductivity modulation devices.

## Patentansprüche

1. Verfahren zum Herstellen eines Isolierschicht-Feldeffekttransistors mit den folgenden Schritten:
a) epitaxiales Wachsen einer niedrig dotierten Siliziumschicht (2) eines ersten Leitungstyps auf einem hoch dotierten monokristallinen Siliziumsubstrat;
b) Oberflächenoxidation der niedrig dotierten Siliziumschicht (2) und Musterbildung zur Formung von Feld-Oxidbereichen (4);
c) Implantierung und Diffusion von Dotierstoffen eines zweiten, dem ersten entgegengesetzten Leitungstyps zur Bildung hoch dotierter tiefer Körperbereiche (3) in der niedrig dotierten Siliziumschicht (2);
d) photolithographisches Entfernen ausgewählter Feld-Oxidbereiche zur Freilegung der Oberfläche der niedrig dotierten Siliziumschicht (2) und der hoch dotierten tiefen Körperbereiche (3);
e) Wachsen einer Puffer-Oxidschicht (12) auf der freigelegten Oberfläche der niedrig dotierten Siliziumschicht (2) und der hoch dotierten tiefen Körperbereiche (3);
f) Ablagern einer Siliziumnitridschicht (13) auf der Puffer-Oxidschicht (12);
g) Bildung eines Musters aus der Siliziumnitridschicht mit Hilfe einer Photoresistmaske und Ätzen der Siliziumnitridschicht (13) zum Freilegen von Siliziumnitridschichtbereichen über den hoch dotierten tiefen Körperbereichen (3) und über der niedrig dotierten Siliziumschicht (2) zwischen den hoch dotierten tiefen Körperbereichen (3) zur Definierung niedrig dotierter Körperbereiche (6) und hoch dotierter Source-Bepeiche (7), die auszubilden sind;
i) Implantieren von Dotierstoffen des zweiten Leitungstyps unter Verbindung der Photoresistmaske und der Siliziumnitridbereiche als Maske und Diffundieren zur Bildung der niedrig dotierten Körperbereiche (6) in der niedrig dotierten Siliziumschicht außer den hoch dotierten tiefen Körperbereichen (3);
j) Entfernen der Puffer-Oxidschicht (12) in den nicht von den Siliziumnitridbereichen (13) bedeckten Bereichen durch Ätzen zur Ausbildung von Puffer-Oxidbereichen unter den Siliziumnitridbereichen;
k) Implantieren von Dotierstoffen des ersten Leitungstyps und nachfolgendes Diffundieren unter gleichzeitiger Oberflächenoxidation unter Verwendung der Siliziumnitridbereiche und der Puffer-Oxidbereiche als Maske zur Bildung der hoch dotierten Source-Bereiche (7) innerhalb der hoch dotierten tiefen Körperbereiche und der niedrig dotierten Körperbereiche und zur Ausbildung von Oxidbereichen auf den hoch dotierten Source-Bereichen (7);
l) Ablagern und Dotieren einer polykristallinen Siliziumschicht (5) auf der erhaltenen Struktur nach Schritt k); und
m) photolithographische Bildung eines Musters aus der polykristallinen Siliziumschicht und Ätzen der polykristallinen Siliziumschicht zur Bildung eines Gates über den Siliziumnitridbereichen, den Puffer-Oxidbereichen und den Oxidbereichen.

2. Verfahren nach Anspruch 1, bei welchem das monokristalline Siliziumsubstrat vom zweiten Leitungstyp ist, um Leitfähigkeitsmodulationselemente zu bilden.

## Revendications

1. Procédé de fabrication d'un transistor à effet de champ à grille isolée comprenant les étapes suivantes :
a) croissance épitaxiale d'une couche de silicium faiblement dopée (2) ayant un premier type de conductivité sur un substrat de silicium monocristallin fortement dopé ;
b) oxydation de surface de la couche de silicium faiblement dopée (2) et masquage pour former des régions d'oxyde de champ (4) ;
c) implantation et diffusion d'impuretés d'un second type de conductivité opposé au premier type de conductivité pour former des régions de corps profondes fortement dopées (3) dans la couche de silicium faiblement dopée (2) ;
d) enlèvement de régions d'oxyde de champ choisies par photolithographie pour exposer la surface de la couche de silicium faiblement dopée (2) et les régions de corps profondes fortement dopées (3) ;
e) croissance d'une couche d'oxyde de plot (12) sur la surface exposée de la couche de silicium faiblement dopée (2) et des régions de corps profondes fortement dopées (3) ;
f) dépôt d'une couche de nitrure de silicium (13) sur la couche d'oxyde de plot (12) ;
g) masquage de la couche de nitrure de silicium par un masque photosensible et gravure de la couche de nitrure de silicium (13) pour laisser des régions de couche de nitrure de silicium sur les régions de corps profondes fortement dopées (3) et sur la couche de silicium faiblement dopée (2) entre les régions de corps profondes fortement dopées (3) pour définir des régions de corps faiblement dopées (6) et des régions de source fortement dopées (7) à former ;
i) implantation d'impuretés du second type de conductivité en utilisant le masque photosensible et les régions de nitrure de silicium comme masque et diffusion pour former les régions de corps faiblement dopées (6) dans la couche de silicium faiblement dopée, à côté des régions de corps profondes fortement dopées (3) ;
j) enlèvement de la couche d'oxyde de plot (12) dans les zones non recouvertes par les régions de nitrure de silicium (13) en gravant pour former des régions d'oxyde de plot en dessous des régions de nitrure de silicium ;
k) implantation d'impuretés du premier type de conductivité suivie d'une diffusion accompagnée d'une oxydation de surface en utilisant les régions de nitrure de silicium et les régions d'oxyde de plot comme masque pour former les régions de source fortement dopées (7) dans les régions de corps profondes fortement dopées et les régions de corps faiblement dopées et pour former des régions d'oxyde sur les régions de source fortement dopées (7) ;
l) dépôt et dopage d'une couche de silicium polycristallin (5) sur la structure obtenue après l'étape k) ; et
m) masquage de la couche de silicium polycristallin en utilisant une photolithographie et une gravure de la couche silicium polycristallin pour former une grille sur les régions de nitrure de silicium, les régions d'oxyde de plot et les régions d'oxyde.

2. Procédé selon la revendication 1, dans lequel le substrat de silicium polycristallin est du second type de conductivité pour fournir des dispositifs à modulation de conductivité.
